(19) Europäisches Patentamt
European Patent Office
Office européen des brevets

(11) **EP 2 573 824 A1**

(12) **EUROPEAN PATENT APPLICATION**
published in accordance with Art. 153(4) EPC

(43) Date of publication:
**27.03.2013 Bulletin 2013/13**

(21) Application number: **11783533.0**

(22) Date of filing: **17.05.2011**

(51) Int Cl.:
*H01L 31/042* (2006.01)   *B32B 27/00* (2006.01)
*B32B 27/32* (2006.01)   *B32B 27/36* (2006.01)

(86) International application number:
**PCT/JP2011/061285**

(87) International publication number:
**WO 2011/145599 (24.11.2011 Gazette 2011/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.05.2010 JP 2010115955**

(71) Applicant: **Toray Advanced Film Co., Ltd.**
**Chuo-ku**
**Tokyo 103-0021 (JP)**

(72) Inventors:
• **KOBAYASHI, Ryosuke**
**Mishima-shi**
**Shizuoka 411-0824 (JP)**

• **TANIGUCHI, Kouji**
**Takatsuki-shi**
**Osaka 569-0807 (JP)**
• **NOURA, Souta**
**Mishima-shi**
**Shizuoka 411-0824 (JP)**
• **TANAKA, Shigeru**
**Takatsuki-shi**
**Osaka 569-0807 (JP)**
• **TERANISHI, Masayoshi**
**Mishima-shi**
**Shizuoka 411-0824 (JP)**

(74) Representative: **Kador & Partner**
**Corneliusstrasse 15**
**80469 München (DE)**

(54) **BACKSIDE PROTECTIVE SHEET FOR SOLAR CELL MODULE**

(57)   The present invention provides a solar cell module reverse face protection sheet that reduces the absorption of sunlight to depress temperature rise in a solar cell module and serves for efficient use of reflected light for power generation, thereby ensuring a high power generation efficiency and maintaining a high partial discharge voltage. It is a solar cell module reverse face protection sheet comprising a white polyolefin film and a hydrolysis resistant polyester film, wherein the absorptance is 10% or less for light in the wavelength range of 400 to 2,200 nm coming through the white polyolefin film while the reflectance for light in the above wavelength range is 70% or more.

Figure 1

**Description**

Technical field

the present invention relates to a reverse face protective sheet for solar cell modules, and more specifically it relates to a solar cell module reverse face protective sheet in which the sheet has a decreased degree of sunlight absorption to serve for preventing temperature rise in a solar cell module and has an increased sunlight reflectance to enhance the quantity of retroreflection back to the solar cell, thereby increasing the power generation efficiency of the solar cell.

Background art

Increased attention is now focused on sunlight as an inexhaustible, nonpolluting, new energy source, and efforts have been rapidly strengthened in the field of photovoltaic power generation aiming to establish power generation systems that are clean and environment-friendly. Solar cells incorporating thin-film devices made of, for instance, amorphous silicon, have been in rapidly growing use in recently years, and currently they are often installed on roofs of general households to serve as power source.

For installation on roofs, solar cells are combined with a plurality of photovoltaic devices to form solar cell modules whose faces are protected with appropriate covering material. In general, a solar cell module consists of a surface protection sheet or glass, adhesive resin layer, photovoltaic device, adhesive resin layer, and reverse face protection sheet.

Material proposed for the reverse face protection sheet of a solar cell module includes a laminate composed of a light reflection film, metal oxide deposited layer, and hydrolysis resistant polyester film. (Patent document 1)
In addition, reverse face protection sheets are required to have a resistance to a partial discharge voltage of 700 V to 1,000 V, depending on power generation capacity, to protect the solar cell module from damage caused by applied voltage, and some methods have been proposed to improve the partial discharge characteristics. Such methods proposed to improve the partial discharge characteristics include, for instance, providing an antistatic layer on either surface of a reverse face protection sheet (Patent document 2).

In this respect, a solar cell module suffers a temperature rise resulting from absorption of energy in the wavelength region of sunlight by the reverse face protection sheet exposed to sunlight, as well as heat generation from the photovoltaic device that performs power generation in the solar cell itself. It is reported that the temperature of the overall solar cell module can increase to nearly 80°C under calm conditions at midsummer.

When a common single crystal silicon cell is used as photovoltaic device, the output is decreased by 4 to 5% per 10°C of temperature rise, and accordingly, as large as a 20% decrease in output can take place if the temperature of the single crystal silicon cell rises by 40°C .

In the present-day solar cell industry where serious competitive efforts are made aiming for a 1% improvement in power generation efficiency, prevention of temperature rise in solar cell modules is a pressing issue, and it is proposed to use a laminated reverse face protection sheet for solar cell modules in which a specific colored resin layer has an absorptance of 10% or less in the wavelength range of 800 to 1,400 nm to prevent heat from being generated by absorption of light in the sunlight wavelength range. (Patent document 3)
However, problems can still arise even if the absorptance is decreased in only some of the layers that constitute the laminated reverse face protection sheet for solar cell modules, because temperature rise may take place in other layers that absorb sunlight to increase the temperature of the solar cell module. In addition, light in the wavelength range of 800 to 1,400 nm accounts for only about 30% of the overall sunlight energy, and depression of heat generation in a solar cell module requires decreasing the absorptance in a wider wavelength range to prevent heat generation in the solar cell module reverse face protection sheet that is exposed to sunlight.

Furthermore, the heat generation that accompanies power generation by photovoltaic devices also has a large influence on the temperature rise in a solar cell module, and therefore, it is also required to remove heat quickly from the photovoltaic devices.

Prior art documents

Patent documents

Patent document 1:    Japanese Unexamined Patent Publication (Kokai) No. 2006-253264
Patent document 2:    Japanese Unexamined Patent Publication (Kokai) No. 2009-147063

Patent document 3:     Japanese Unexamined Patent Publication (Kokai) No. 2009-181989

Summary of the invention

Problems to be solved by the invention

The present invention is designed to solve these problems with conventional type solar cell modules, and aims to provide a solar cell module reverse face protection sheet in that serves for depressing temperature rise in the solar cell module to improve its power generation efficiency. Means of solving the problems

The solar cell module reverse face protection sheet according to the present invention is characterized in that it includes a white polyolefin film containing white fine particles and a hydrolysis resistant polyester film with a retained tensile elongation rate of 60% or more after 10-hour storage in high pressure steam at 140°C, wherein the absorptance is 10% or less when the white polyolefin film is exposed to light in the wavelength range of 400 to 2,200 nm while the reflectance for light in the above wavelength range is 70% or more.

The present invention further relates to a solar cell module reverse face protection sheet characterized in that it preferably has a heat transmission coefficient of 500 W/m$^2$K or more and preferably has a partial discharge voltage of 1,000 V or more.

The present invention further relates to a solar cell module reverse face protection sheet characterized in that the aforementioned white polyolefin film includes three layers in the form of A1 layer / B1 layer / C1 layer, wherein the A-layer is formed of a mixture of an ethylene / $\alpha$-olefin copolymer, a low density polyethylene, and a propylene based resin, the B-layer being formed of an ethylene / $\alpha$-olefin copolymer containing 5 to 30 wt% of white fine particles, and the Cl layer being formed of a mixture of an ethylene / $\alpha$-olefin copolymer, a low density polyethylene, and a propylene based resin.

The present invention further relates to a solar cell module reverse face protection sheet in the form of a white polypropylene based multi-layered film characterized in that the aforementioned white polyolefin film includes three layers in the form of A2 layer / B2 layer / C2 layer, wherein the A2 layer is formed of a mixture of polyethylene and a polypropylene based resin, the B2 layer being formed of a polypropylene based resin containing 5 to 50 wt% of white fine particles, and the C2 layer being formed of a polypropylene based resin.

Effect of the invention

The solar cell module reverse face protection sheet according to the present invention has an absorptance of 10% or less for light in the wavelength region 400 to 2,200 nm, which accounts for about 90% of the total sunlight energy, leading to a reduction in the total heat generation in the solar cell module reverse face protection sheet. In addition, it has a reflectance of 70% or more for light in the wavelength region 400 to 2,200 nm so that the reflected light to returns into the photovoltaic device, thereby improving the power generation efficiency of the solar cell.

Furthermore, it has a heat transmission coefficient of 500 W/m$^2$K or more so that the heat resulting from power generation in the photovoltaic device is diffused quickly to depress temperature rise in the photovoltaic device, thereby preventing a decrease the power generation efficiency of the solar cell.

Brief description of the drawings

[Fig. 1] Fig. 1 illustrates a solar cell module.
[Fig. 2] Fig. 2 illustrates the structure of an embodiment of the solar cell module reverse face protection sheet according to the present invention.
[Fig. 3] Fig. 3 illustrates the structure of another embodiment of the solar cell module reverse face protection sheet according to the present invention.

Description of embodiments

The solar cell module reverse face protection sheet according to the present invention is a component of a solar cell module, and the solar cell module reverse face protection sheet is described below with reference to drawings.

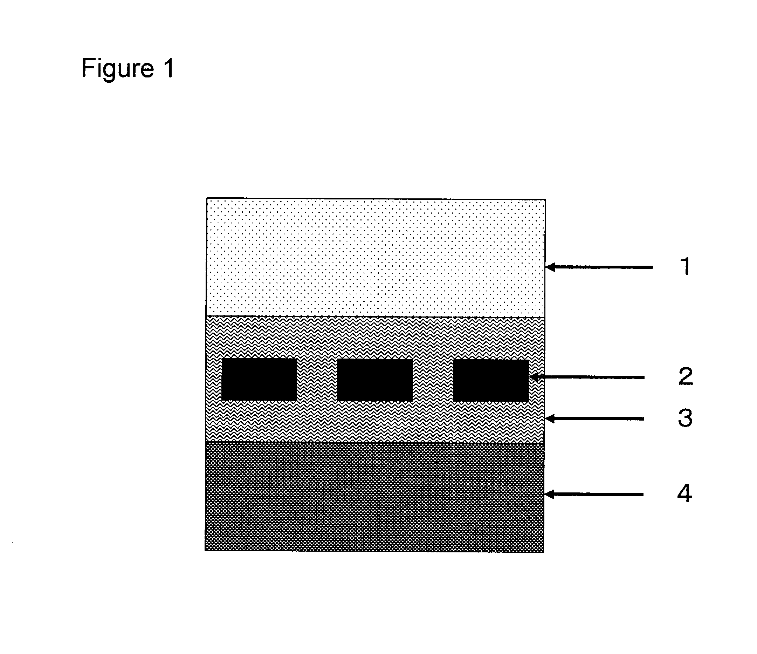

Fig. 1 gives a cross section view of an embodiment of the solar cell module. It includes a surface glass (or surface protection sheet) 1, photovoltaic devices 2, an adhesive resin layer 3, and a reverse face protection sheet 4. Sunlight is incident to the surface glass, passes through the adhesive resin layer 3, and reaches the photovoltaic devices 2 to cause electromotive force. The light reflected by the reverse face protection sheet is then reflected by the interface between the surface glass and the adhesiveness resin and reaches the photovoltaic devices 2 to contribute again to power generation.

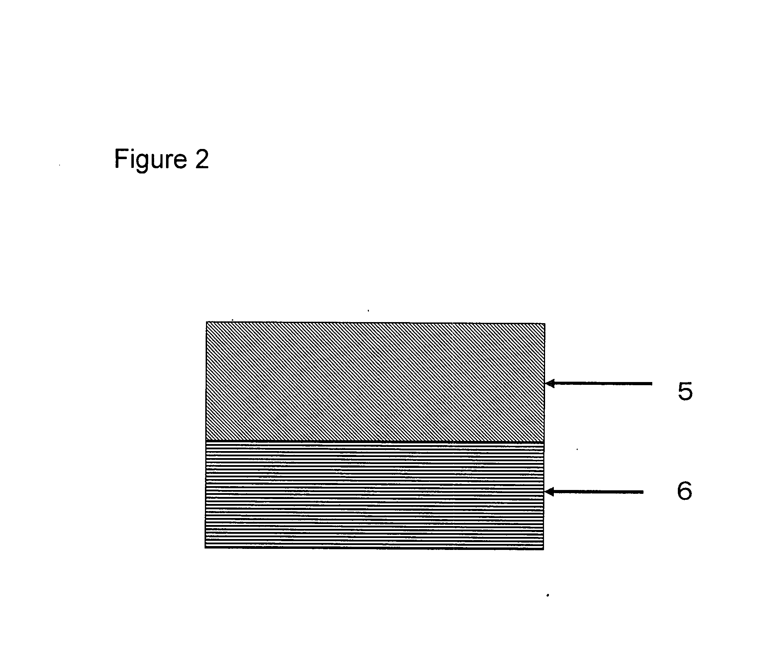

Fig. 2 gives a cross section view of an embodiment of the solar cell module reverse face protection sheet. It consists of a white polyolefin film 5 and a hydrolysis resistant polyester film 6, stacked in this order from the light irradiated side.

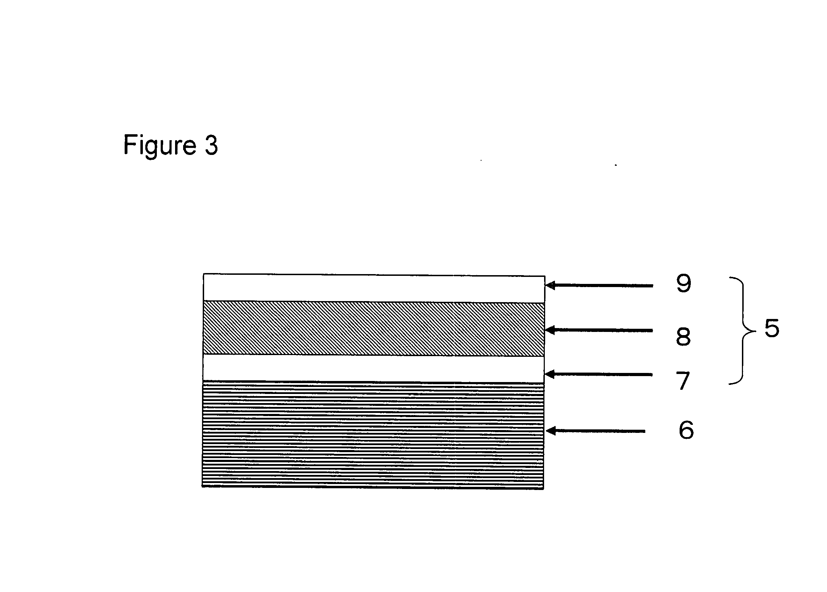

Fig. 3 gives a cross section view of another embodiment of the solar cell module reverse face protection sheet. The white polyolefin film 5 has a three-layered structure consisting of a first layer (A1 layer or A2 layer) 7, a second layer (B1 layer or B2 layer) 8, and a third layer (C1 layer or C2 layer) 9.

The solar cell module reverse face protection sheet according to the present invention includes a white polyolefin film and a hydrolysis resistant polyester film as described above. However, another resin layer, metal foil, metal deposited film, metal oxide deposited film, or the like may exist between the white polyolefin film and the hydrolysis resistant polyester film if it suits the aim of the present invention, or a resin layer that serves for bonding to the adhesive resin layer may be provided on the surface of the white polyolefin film.

Common white polyolefin films are formed of polyolefin produced by homopolymerization of or copolymerization of a plurality of $\alpha$-olefin monomers such as include ethylene, propylene, 1-butene, 1-pentene, 4-methyl- 1-pentene, 1-hexene, 1-heptene, and 1-octene, but the white polyolefin film to be used for the present invention is preferably a white polyethylene based film or white polypropylene based film of a polymer formed mainly of polyethylene or polypropylene, respectively, from the viewpoint of economic efficiency of the film. As compared with white polyethylene based films, white polypropylene based films are higher in heat resistance, suffer from less deformation when processed at a high temperature under a high pressure during the molding of a solar cell reverse face protection sheet, and therefore, they are preferred when the processing temperature is high.

A white polyolefin film can be produced by molding such a polyolefin in to a film after adding white fine particles. White fine particles may be scattered over the entire film, but it is preferable that the film has a three-layered structure in the form of first layer / second layer / third layer, of which only the contains particles, to prevent streaks caused by dirt on the orifice during melt-extrusion of the film and prevent defects from being caused in the film by dirt removed from the orifice. Here, it may also be effective to use a film with a layered structure consisting of four or more layers, and add white fine particles to a layer other than the outermost ones in order to prevent defects during film production as described above.

A white polyethylene film can be produced by molding a polyethylene based resin into a film after adding white fine particles. Polyethylene as referred to herein is a resin of an ethylene homopolymer or a copolymer of ethylene and an $\alpha$-olefin, and its examples include medium and high density polyethylene (hereinafter abbreviated as HDPE) with a density of 0.925 g/cm$^3$ or more, high-pressure-produced low density polyethylene (hereinafter abbreviated as LDPE) with a density of 0.910 to 0.930 g/cm$^3$, and straight-chain low density polyethylene (hereinafter abbreviated as LLDPE) with a density of 0.910 to 0.938 g/cm$^3$. In particular, LLDPE is preferable because it is able to form a tough film and less likely to suffer from cleavages after being laminated with another film such as polyethylene terephthalate (hereinafter abbreviated as PET) which is used as material for a hydrolysis resistant polyester film for the present invention.

The above polyethylene based resin may contain another resin that has a higher melting point than that of the polyethylene based resin in order to enhance the heat resistance and bending strength of the film. Examples include polypropylene based resin, fluorine based resin, polyester based resin, and polyetherimide, of which polypropylene based resin is preferable from the viewpoint of high processability during molding by melting extrusion.

A white polyethylene based film can be produced by molding a polyethylene based resin after adding white fine particles of titanium oxide, silica, alumina, calcium carbonate, barium sulfate, or the like. A preferable method for adding white fine particles to a polyethylene based resin is by first preparing master pellets containing white fine particles at a high 40 to 60 wt% content, mixing them uniformly with an appropriate quantity of diluting pellets of a polyethylene based resin free from white fine particles, and feeding them to an extruder. This ensures increased dispersion of fine particles in a polyethylene based resin.

It is preferable that the white fine particles are of titanium oxide, which has the highest reflectance. There are no specific limitations on their average particle diameter, but it is preferably in the range of 200 to 300 nm so that they, after being dispersed uniformly in a resin, has an increased reflectance for visible light. In this respect, it is preferable that the particles to be added have an average particle diameter of 400 to 500 nm from the viewpoint of increasing the reflectance for infrared light. It is more preferable to mix particles having an average particle diameter of 200 to 300 nm with those particles having an average particle diameter of 400 to 500 nm to ensure a high reflectance for both visible light and infrared light. There are no specific limitations on the type of titanium oxide particles. Crystals of the rutile, anatase, and brookite type are generally known, of which rutile type crystals are preferable because of their good characteristics including high whiteness, weather resistance, and light reflectivity. Titanium oxide can work as a light catalyst to degrade the resin, and therefore, its particles preferably have coated surfaces to reduce the light catalyst action. There are no specific limitations on the composition, but an inorganic oxide such as silicon oxide, alumina, and zinc oxide is preferable. There are no specific limitations on the method to be adopted to coat the particles with a surface coating agent, and titanium oxide particles processed by a generally known method may be used.

Another effect of adding white fine particles to a white polyethylene based film is increasing the heat conductivity of the white polyethylene based film so that heat generated in a solar cell module can be quickly diffused towards and dissipated though the reverse surface. Of the white fine particles listed above, silica and alumina can serve effectively to increase heat conductivity, and it is preferable that they are combined with other white fine particles for addition.

To further increase the whiteness, it is effective to use a fluorescent brightening agent such as 2,5-bis(5-t-butyl-2-benzoxazolyl) thiophene. Addition of a fluorescent brightening agent is preferable because it absorbs light in the ultraviolet ray region that does not contribute to power generation while emitting light in the visible light region, thereby serving to improve the power generation efficiency. From the viewpoint of effective improvement in fluorescent emission rate, it is preferable that the fluorescent brightening agent accounts for 0.05 wt% or more, more preferably 0.1 wt% or more, as a component in the B-layer resin. A content of 3 wt% or less serves to depress the weather resistance of the white polyethylene based film that can result from modification of the fluorescent brightening agent caused by exposure to ultraviolet light, high temperature, or high humidity, and it is more preferably 1.5 wt% or less.

An exemplary production method for a white polyethylene based film to be used for the present invention is blending polyethylene pellets containing a large amount of white fine particles with polyethylene pellets free from white fine particles, feeding the blend to a melt extruder, causing it to pass through an appropriate filter, extruding it through a slit die to form a sheet, bring it in closely contact with a casting drum by applying static electricity, and cooling it for solidification.

The white polyolefin film used in the solar cell module reverse face protection sheet according to the present invention is preferably a three-layered film as described above. It is preferable that it includes three layers in the form of A1 layer / B1 layer / C1 layer, wherein the A1 layer is formed of a mixture of an ethylene / $\alpha$-olefin copolymer, a low density polyethylene (LDPE), and a polypropylene based resin, the B-layer being formed of an ethylene / $\alpha$-olefin copolymer containing 5 to 30 wt% of white fine particles, and the C1 layer being formed of a mixture of an ethylene /$\alpha$-olefin copolymer, a low density polyethylene (LDPE), and a polypropylene based resin. Described below is the white polyethylene based multi-layered film including three layers in the form of A1 layer / B1 layer / C1 layer. Here, it is assumed that a hydrolysis resistant polyester film is laminated to the surface of the C1 layer.

The ethylene / $\alpha$-olefin copolymer to be used in the A1 layer is LLDPE produced by random copolymerization of ethylene with a small amount of an $\alpha$-olefin, and preferably has a density of 0.920 to 0.938 g/cm$^3$. A density of less than 0.938 g/cm$^3$ serves to prevent resin from being removed by abrasion with a metal roll, rubber roll, or the like, and easily achieve a required interlaminar strength with adhesiveness resin used in a solar cell module, while a density of more than 0.920 g/cm$^3$ serves to ensure good slip properties and handleability and produce a solar cell reverse face sheet with a high partial discharge voltage.

In the A1 layer, it is preferable that the ethylene / $\alpha$-olefin copolymer accounts for 65 to 95 wt% while the mixture resin consisting of LDPE and a polypropylene based resin accounts for 35 to 5 wt%. The addition of LDPE serves to improve the crystallinity of the LLDPE and increase Young's modulus. The addition of a polypropylene based resin, on the other hand, improves slip properties and blocking resistance.

If the content of the mixture resin of LDPE and a polypropylene based resin is maintained at 5 wt% or more, the film has a high bending strength and good slip properties, leading to smooth travelling through the film wind-up step and the lamination step. If the content is maintained at 35 wt% or less, on the other hand, the crystallization of the resin components that constitute the A1 layer is maintained at an appropriate speed, allowing the layer to come in good contact with the casting drum to ensure the production of a film with high planarity and smoothness.

The mixing ratio of the LDPE and a polypropylene based resin in the mixture resin is preferably such that LDPE accounts for 10 to 40 wt% while the polypropylene based resin accounts for 90 to 60 wt%. In particular, from the viewpoint of prevention of sticking during processing, the mixing ratio is preferably such that LDPE accounts for 15 to 30 wt% while the polypropylene based resin accounts for 85 to 70 wt%.

The LDPE resin preferably has a density of 0.890 to 0.920 g/cm$^3$. A density of 0.890 g/cm$^3$ or more ensures desired slip properties and handleability. As the density exceeds 0.920 g/cm$^3$, however, the degree of crystallinity in these layers will become too large, and the resin will be abraded easily due to contact with a metal roll or rubber roll during film production or processing, leading to removal of surface resin and generation of white powder.

Examples of the above propylene based resin include homopolypropylene, and random or block copolymers of ethylene and propylene. If a copolymer of ethylene and propylene is to be used, it is preferable that that the ethylene accounts for 1 to 7 mol% to improve slip properties while maintaining heat resistance. If a film with high strength is required, it is preferable that to add a nucleating agent as necessary.

It is preferable that the B1 layer is formed of an ethylene / $\alpha$-olefin copolymer containing 5 to 30 wt% of white fine particles. The ethylene / $\alpha$-olefin copolymer referred to herein is a LLDPE that is produced by random copolymerization of an ethylene material as used in the A-layer and C-layer with a small amount of an $\alpha$-olefin.

It is preferable that the B1 layer contains 5 to 30 wt% of white fine particles. If rutile type titanium oxide particles coated with an inorganic oxide having an average particle diameter of 200 to 500 nm are added to a content of 5 to 30 wt%, it is preferable because the resulting layer will have a high light reflectivity and, when used as reverse face protection sheet of a solar cell, it serves to reflect light leaking from between photovoltaic devices in the solar cell, leading to an increased power generation efficiency. A content of 5 wt% or more ensures develop of an adequate light reflection effect, while a content of less than 30 wt% ensures adequate dispersion in the resin, serving to avoid problems such as film breakage during film production or other steps including lamination and formation of fine cracks in the film that can cause deterioration in electric characteristics or serious changes in color.

To maintain resistance to ultraviolet light, temperature, and humidity, a phosphorus-phenolic antioxidant may be added as a resin component of the B1 layer to accounts for 0.01 to 0.3 wt% of the B1 layer. Antioxidants other than the phosphorus-phenolic antioxidants can cause yellowing even if they can ensure weather resistance to prevent oxidation degradation from being caused by ultraviolet light or temperature / humidity. Antioxidants other than the phosphorus-phenolic antioxidants, furthermore, tend to be so high in thermal vaporization rate that may form an eye-mucus-like material that is attached to the orifice lip portion during heated extrusion to cause surface defects in the film. A phosphorus-phenolic antioxidant can be effective if its content is 0.01 wt% or more, while it can decrease in dispersibility or evaporate to form an eye-mucus-like material that is attached to the orifice lip portion to cause surface defects if it accounts for more than 0.3 wt%.

Usable phosphorus-phenolic compound based antioxidants include, for instance, 2,10-dimethyl-4,8-di-t-butyl-6-[3-(3,5-di-t-butyl-4-hydroxyphenyl) propoxy]-12H-dibenzo [d,g] [1,3,2] dioxadioxaphosphocin, 2,4,8,10-tetra-t-butyl-6-[3-(3,5-di-t-butyl-4-hydroxyphenyl) propoxy] dibenzo [d,f] [1,3,2] dioxaphosphepin 2,4,8,10-tetra-t-butyl-6-[3-(3,5-di-t-butyl-4-hydroxyphenyl) propionyl oxy]-dibenzo [d, f] [1,3,2] dioxaphosphepin, of which 2,4,8,10-tetra-t-butyl-6-[3-(3,5-di-t-butyl-4-hydroxyphenyl) propionyl oxy]-dibenzo [d, f] [1,3,2] dioxaphosphepin (Sumilizer (registered trademark) GP, supplied by Sumitomo Chemical Co., Ltd.) is preferable because of high dispersibility in resin and high effectiveness. Antioxidants other than the phosphorus-phenolic antioxidants, such as, for instance, a phosphorus based antioxidant, phenolic antioxidant, amine based antioxidant, and sulfur based antioxidant may be used in combination, but their content is preferably 0.05 wt% or less from the viewpoint of vaporization prevention and color protection.

Scrapings that result from production of white polyolefin based multi-layered film for the present invention may be recovered for recycling. Specifically, scrapings may be pelletized and added as a B1 layer resin component to account for 5 to 50 wt% in the B1 layer. Common pelletization methods include, but not limited to, a process consisting of pulverization, melt extrusion, and cutting.

Resin to be used to form the C1 layer may be one selected from those listed for the A1 layer, and the resin composition for the A1 layer may be identical to or different from the resin composition for the C1 layer.

It is preferable that the A1 layer, the B1 layer, and the C1 layer that constitute the layered structure of the white polyethylene based multi-layered film account for 3 to 30%, 60 to 96%, and 1 to 10%, respectively. To prevent curling of the film, it is preferable that the thickness of the C1 layer is smaller than that of the A 1 layer, particularly, 2/3 or less of the thickness of the A 1 layer.

For instance, in cases where white polyethylene based multi-layered film is produced by the T-die melt molding method and where the A1 layer is in contact with a cooling drum during the casting of a melt-extruded sheet on the cooling drum, the A1 layer is cooled rapidly by the cooling drum while the C1 layer, which is not in contact with the drum, is cooled slowly, and the difference in crystallization rate will cause curling. Thus, it becomes likely that curling takes place with the C1 layer being the inner side. Therefore, it is preferable that the thickness of the C1 layer, which cools slowly, is smaller than that of the A-layer, which cools rapidly. If the thickness of the C1 layer exceeds 2/3 of that of the A-layer, the film may suffer from significant curling, possibly leading to shearing of the film during a take-up step or fabrication.

Furthermore, the white polyethylene based multi-layered film has a Young's modulus in the range of 150 to 400 MPa, preferably 250 to 350 MPa, in both the length direction and the width direction to ensure high windability during film production and handleability during fabrication steps such as lamination. If the Young's modulus is less than 150 MPa, windability may be low during film production and a large tension may take place during fabrication steps such as lamination, causing the film to be stretched and resulting in low processability and an irregular shape of winding. If it exceeds 400 MPa, on the other hand, the film may become rigid, leading to a low windability or suffering from breakage and cracking of the film during fabrication steps such as lamination.

The aforementioned white polyolefin film may be a white polyethylene based film, or may be, as another embodiment, a white polypropylene based film, or may be a white polypropylene based multi-layered film that includes three layers in the form of A2 layer / B2 layer / C2 layer, wherein the A2 layer is formed of a mixture of polyethylene and a polypropylene based resin, the B2 layer being formed of a polypropylene based resin containing 5 to 50 wt% of white fine particles, and the C2 layer being formed of a polypropylene based resin. Described below is a white polypropylene based multi-layered film including three layers in the form of A2 layer / B2 layer / C2 layer. Here, it is assumed that a hydrolysis resistant polyester film is laminated to the surface of the C2 layer.

Polyethylene materials that can be used as the A2 layer include LLDPE, LDPE, HDPE, and mixture resins thereof.

LLDPE materials to be used preferably have a melting point in the range of 110 to 130°C. A melting point of 130°C or less is preferable because the material will achieve strong thermal adhesion with the adhesive resin layer of a solar cell module, while a melting point of 110°C or more is preferable because the sheet will not suffer from a decrease in thickness and will maintain a required partial discharge voltage when heat-bonded to the adhesive resin layer.

The aforementioned LLDPE preferably has a density of 0.900 g/cm$^3$ or more. It is more preferable that the density of 0.940 g/cm$^3$ or less because the material decreases in dispersibility in a polypropylene based resin as the density exceeds 0.940 g/cm$^3$, allowing the resin to be abraded easily due to contact with a metal roll or rubber roll to cause removal of surface resin and generation of white powder.

The aforementioned LDPE preferably has a density in the range of 0.900 to 0.930 g/cm$^3$. A density of 0.900 g/cm$^3$ or more is preferable because it ensures that the can have good slip properties and handleability during processing. A density of 0.930 g/cm$^3$ or less, on the other hand, can effectively improve the dispersibility of polyethylene in a polypropylene based resin.

Mixing of the aforementioned LLDPE and LDPE is preferable because the dispersibility of polyethylene in a polypropylene based resin is improved, and the resistance to cohesive failure in the A2 layer is improved. It is preferable that LDPE is added so as to account for 3 to 30 wt% in the entire polyethylene material.

In the A2 layer, it is preferable that polyethylene accounts for 20 to 60 wt% while a polypropylene based resin accounts for 80 to 40 wt%. A polypropylene based resin content of 80 to 40 wt% is preferable because it serves to improve the heat resistance and the bonding strength with the B2 layer. A polypropylene based resin content of 80 wt% or less ensures required contact with an adhesive resin layer, while a content of 40 wt% or more ensures a required heat resistance and is expected to improve the strength of bonding with the B-layer.

The aforementioned heat resistance refers to the durability to the lamination step performed at a high temperature of 130 to 170°C which the material, which is used as a solar cell module reverse face protection sheet, is subjected to during molding to a solar cell module. More specifically, the resin that forms the reverse face protection sheet is deformed as heat and pressure are applied during the lamination step in the production process for a solar cell module containing wiring such as bus bars, but it is preferable that 80% or more of the initial thickness is maintained. If the initial thickness is maintained, it is possible to produce a solar cell module that has good appearance without the wiring members such as bus bars becoming visible through the sheet. The electric strength values such as dielectric breakdown voltage and partial discharge voltage are characteristic values of a resin, which are in direct proportion to the thickness of the film, and therefore, the initial design electric characteristics can be maintained by ensuring a required thickness before the start of processing.

When the processing temperature is in the range of 130 to 150°C, it is preferable that the polypropylene based resin accounts for 40 to 60 wt%, while when the processing temperature is in the range of 150 to 170°C, it is preferable that the polypropylene based resin accounts for 60 to 80 wt%.

Usable polypropylene based resins include homopolypropylene, ethylene / propylene random copolymers, and ethylene / propylene block copolymers, of which ethylene / propylene random copolymers are preferable from the viewpoint of heat resistance, slip properties, film handleability, and dispersibility in polyethylene.

It is preferable that the polypropylene based resin has a melting point in the range of 140°C to 170°C from the viewpoint of heat resistance, slip properties, film handleability, curling resistance, and thermal adhesiveness to an adhesive resin layer. A melting point of 140°C or more is preferable because the A2 layer will be so high in heat resistance that it will not suffer from problems such as a decrease in sheet thickness and a decrease in partial discharge voltage when used as a solar cell reverse face sheet and heat-bonded to an adhesive resin layer. A melting point of 170°C or less is preferable because it serves to maintain a strong contact with an adhesive resin layer.

In addition, addition of a polypropylene based resin that is incompatible with polyethylene serves to cause the film surface to have irregularities and hence, improved slip properties. This ensures high windability and processability during film production and slitting. If the film has poor slip properties, on the other hand, air trapped during a slitting or other step will not escape easily and the trapped air can cause partial deformation of the film shape and, in some cases, blocking between different parts of the film which can lead to damage to the film when it is unwound.

It is preferable that the A2 layer has a surface average roughness Ra of 0.10 to 0.30 μm to maintain required film handleability during processing.

Described next is the B2 layer which is formed of a polypropylene based resin composition containing white fine particles. From the viewpoint of heat resistance, it is preferable that the polypropylene based resin composition referred to herein is either a resin in which the polypropylene based resin component is one or more selected from the group consisting of homopolypropylene and random or block copolymers of ethylene and propylene, or a mixture resin of these resins with polyethylene, wherein the polyethylene accounts for less than 30 wt% of the entire resin component.

If a copolymer of ethylene and propylene is uses as the polypropylene based resin, it is preferable from the viewpoint of heat resistance that the ethylene content is 15 mol% or less.

The white fine particles to be used in the B2 layer of the white polypropylene based multi-layered film may be selected from those listed above for the white polyethylene film.

It is preferable that the white fine particles in the B2 layer account for 5 to 50 wt%, more preferably 10 to 30 wt%. A content of 5 wt% or more ensures adequate whiteness and light reflection performance, and serves to produce a product that has good appearance without the wiring members such as bus bars becoming visible through the sheet. The upper limit of 50 wt%, on the other hand, means that a larger content will not work to further increase the whiteness and invisibility and that a smaller content can ensure adequate dispersion of white fine particles in resin and stable film production.

Described next is the C2 layer which is formed of a polypropylene based resin composition. As in the case of the B2 layer, it is preferable that from the viewpoint of heat resistance that it is formed mainly of one or more polypropylene based resins selected from the group consisting of homopolypropylene and random or block copolymers of ethylene and propylene, in which the polypropylene based resin component accounts for 70 wt% or more. In particular, the layer is preferably formed of an ethylene / propylene block copolymer or homopolypropylene from the viewpoint of heat resistance, slip properties, film handleability, surface invulnerability, and resistance to curling. It is preferable that the polypropylene based resin has a melting point in the range of 150°C to 170°C from the viewpoint of heat resistance, slip properties, film handleability, surface invulnerability, and curling resistance.

The white polypropylene based multi-layered film preferably has a Young's modulus in the range of 300 to 1000 MPa to ensure high windability during film production and handleability during fabrication steps such as lamination.

There are no specific limitations on the lamination ratio for the A2 layer / B2 layer / C2 layer structure of a white polypropylene based multi-layered film, but it is preferable that the A2 layer and the C2 layer each account for 5 to 20% while the B2 layer accounts for 90 to 60%.

As described above, the white polyethylene based or the white polypropylene based multi-layered film has a layered structure in the form of A1 layer / B1 layer / C1 layer or A2 layer / B2 layer / C2 layer so that the B1 layer or the B2 layer, which contains white fine particles, is sandwiched between the A1 layer and the C1 layer or between the A2 layer and the B2 layer. This serves to prevent resin decomposition products containing a large quantity of white fine particles from being attached to the orifice during the produce process and avoid quality problems such as process contamination by removed decomposition products and flaws left on the film.

It is preferable that the A1 and A2 layers and the C1 and C2 layers each contain inorganic and/or organic fine particles with an average particle diameter of 1 to 5 $\mu$m with a resin content of 0.1 to 5 wt% with the aim of improving the film handleability and slip properties. Examples of usable fine particles to be added include, for instance, inorganic particles such as wet silica, dry silica, colloidal silica, aluminum silicate, and calcium carbonate, and organic particles formed mainly of crosslinked styrene, silicone, acrylic acid, methacrylic acid, and divinylbenzene. Of these, aluminum silicate and crosslinked polymethyl methacrylate (PMMA) particles are preferable because they are high in dispersibility in resin, effective in improving slip properties even if added in a small amount, and low in price.

Depending on the structure of the solar cell to be constructed, the optimum thickness of the white polyethylene based or white polypropylene based multi-layered film is preferably in the range of 10 to 200 $\mu$m, and it is more preferably in the range of 20 to 150 $\mu$m from the viewpoint of film production and processability in lamination with other base materials. From the viewpoint of increased economic efficiency, lightweightness, and heat transmission coefficient, the thickness is preferably as small as possible as long as a required partial discharge voltage is maintained.

A hydrolysis resistant polyester film to be used in the solar cell module reverse face protection sheet according to the present invention has a retained tensile elongation rate of 60% or more after storage for 10 hours in high pressure steam at 140°C. Hydrolysis resistant polyester films are high in heat resistance, moisture resistance, and hydrolysis resistance and serve effectively for protection of solar cell modules.

Polyester to be used for the present invention is a resin produced by condensation polymerization of a diol and a dicarboxylic acid. Usable dicarboxylic acids include phthalic acid, terephthalic acid, isophthalic acid, 2,6-naphtalene dicarboxylic acid, adipic acid, trimethyl adipic acid, sebacic acid, malonic acid, dimethyl malonic acid, succinic acid, oglutaric acid, pimelic acid, 2,2-dimethyl oglutaric acid, azelaic acid, fumaric acid, maleic acid, itaconic acid, 1,3-cyclopentane, dicarboxylic acid, 1,2-cyclohexane dicarboxylic acid, 1,4-cyclohexane dicarboxylic acid, 1,4-naphthalic acid, diphenic acid, 4,4'-oxy benzoic acid, and 2,5-naphthalene dicarboxylic acid. Of these, terephthalic acid, isophthalic acid, 2,6-naphthalene dicarboxylic acid, cyclohexane dicarboxylic acid are preferable, and terephthalic acid, 2,6-naphthalene dicarboxylic acid are particularly preferable.

Usable diols include ethylene glycol, diethylene glycol, polyethylene glycol, propylene glycol, polypropylene glycol, 1,3-propanediol, 1,3-butanediol, 1,4-butanediol, 1,5-pentanediol, 1,6-hexanediol, 1,7-heptanediol, 1,8-octanediol, 1,9-nonanediol, 1,10-decanediol, 2,4-dimethyl-2-ethylhexane-1,3-diols, neopentyl glycol, 2-ethyl-2-butyl-1,3-propanediol, 2-ethyl-2-isobutyl-1,3-propanediol, 3-methyl-1,5-pentanediol, 2,2,4-trimethyl-1,6-hexanediol, 1,2-cyclohexane dimethanol, 1,3-cyclohexane dimethanol, 1,4-cyclohexane dimethanol, 2,2,4,4-tetramethyl-1,3-cyclobutanediol, 4,4'-thiodiphenol, bisphenol A, 4,4'-methylene diphenol, 4,4'-(2-norbomylidene) diphenol, 4,4'-dihydroxy biphenol, o-, m-, and p-dihydroxy benzene, 4,4'-isopropylidene phenol, 4,4'-isopropylidene bis(2,6-dichlorophenol), 2,5-naphthalene diol, p-xylene diol, cyclopentane-1,2-diol, cyclohexane-1,2-diol, and cyclohexane-1,4-diol. Of these, ethylene glycol, 1,3-propanediol, 1,4-butanediol, and 1,4-cyclohexanedimethanol are preferable, and ethylene glycol is particularly preferable.

A hydrolysis resistant polyester film used in the solar cell module reverse face protection sheet according to the present invention preferably has a melting point 250°C or more from the viewpoint of heat resistance, while it is preferably 300°C or less from the viewpoint of productivity. Examples of such polyester include PET, polyethylene-2,6-naphthalate, and poly-1,4-cyclohexylene dimethylene terephthalate.

From the viewpoint of properties such as heat resistance, hydrolysis resistant, weather resistance, and mechanical strength, a hydrolysis resistant polyester film used in the solar cell module reverse face protection sheet according to the present invention is preferably a biaxially stretched film PET produced from terephthalic acid as the dicarboxylic acid component and ethylene glycol as the diol component and having an intrinsic viscosity $[\eta]$ of 0.60 to 1.20, more preferably 0.63 to 1.00, or a biaxially stretched film of polyethylene-2,6-naphthalate produced from 2,6-naphthalene dicarboxylic acid as the dicarboxylic acid component and ethylene glycol as the diol component. Here, for measurement of the intrinsic viscosity $[\eta]$, a polyester film is dissolved in o-chlorophenol used as solvent and the temperature is adjusted to 25°C. This viscosity is in proportion to the polymerization degree of the polyester. An intrinsic viscosity of 0.60 or more is preferable because it will be easy to produce a hydrolysis resistant, heat resistant film, which will serve to produce a reverse face protection sheet and, in turn, a solar cell module with an increased hydrolysis resistance. On the other hand, an intrinsic viscosity of 1.2 or less ensures a decreased melt viscosity, leading to easy melt extrusion and smooth film production.

The polyester may be either a homopolyesters or a copolyester. Examples of copolymerization components include, for instance, diol components such as diethylene glycol, neopentyl glycol, and polyalkylene glycol; and dicarboxylic acid components such as adipic acid, sebacic acid, phthalic acid, isophthalic acid, 2,6-naphthalene dicarboxylic acid, and 5-sodium sulfoisophthalic acid. The polyester may contain, as needed, appropriate additives including, for instance, thermal stabilizer, oxidation-resistant stabilizer, ultraviolet absorber, weatherability stabilizer, organic lubricant, organic fine particles, filler, antistatic agent, nucleating agent, dye, dispersing agent, and coupling agent, as long as they do not impair the effect of the present invention.

To produce a biaxial stretched film of the polyester, a polyester material is dried as needed, fed to a common type melt extruder, extruded through a slit type die to form a sheet, brought in close contact with a metal drum, and cooled to a temperature below the glass transition point of the polyester to prepare an unstretched film. A biaxial stretched film can be produced by processing the unstretched film by a commonly known technique for simultaneous biaxial stretching or sequential biaxial stretching. For this processing, an appropriate stretching temperature may be set in the range from the glass transition point Tg up to Tg+100°C, and commonly, a temperature in the range of 80 to 170°C is preferably from the viewpoint of the physical properties of the finally resulting film and productivity. An appropriate draw ratio may be set in the range of 1.6 to 5.0, preferably 1.7 to 4.5, in both the length direction and the width direction. The stretching speed, furthermore, is preferably in the range of 1,000 to 200,000% / min. The stretched film is then subjected to heat treatment. It may be stretched in the width direction in a tenter and supplied to a heat treatment chamber for continuous heat treatment. Heat treatment may be carried out by heating in a separate oven or using a heating roller. With respect to the heat treatment conditions, the film is commonly treated at a temperature in the range of 120 to 245°C for a duration in the range of 1 to 60 seconds. During the heat treatment, relaxation treatment may be performed with the aim of increasing the thermal dimensional stability in the width direction and the length direction.

To improve the power generation efficiency by preventing a temperature rise due to absorption of light in the sunlight wavelength region and depressing heat generation in photovoltaic devices, the solar cell module reverse face protection sheet according to the present invention should have an absorptance of 10% or less, preferably 7% or less, and more preferably 6% or less, for light with a wavelength of 400 to 2,200 nm coming through the white polyolefin film. An absorptance of 10% or less for light with wavelength of 400 to 2,200 nm serves to depress a temperature rise in the solar cell module and a decrease in the power generation efficiency.

For the solar cell module reverse face protection sheet according to the present invention to have an absorptance of 10% or less for light with a wavelength of 400 to 2200 nm coming in through the white polyolefin film, it is important for the white polyolefin film to have a required reflectance in the above wavelength and also for the hydrolysis resistant polyester film to have a required thickness. Specifically, in the solar cell module reverse face protection sheet according to the present invention, light in the above wavelength is absorbed mainly by the hydrolysis resistant polyester film, and if the reflectance of the white polyolefin film is increased, the quantity of light reaching the hydrolysis resistant polyester film decreases, leading to a decrease in the absorptance of the entire reverse face protection sheet. Here, the absorptance of the hydrolysis resistant polyester film depends on the thickness of the hydrolysis resistant polyester film, and the absorptance increases with an increasing thickness. Furthermore, improving the reflectance of the hydrolysis resistant polyester film by adding white fine particles to the hydrolysis resistant polyester film serves to decrease the quantity of light entering the hydrolysis resistant polyester film, thereby effectively ensuring a decrease in the absorptance as well as an increase in the reflectance as described below.

To improve the power generation efficiency by reflecting light in the sunlight wavelength region and causing it to return into the photovoltaic devices, the solar cell module reverse face protection sheet according to the present invention should have a reflectance of 70% or more, preferably 78% or more, for light with a wavelength of 400 to 2,200 nm coming through the white polyolefin film. A reflectance of 70% or more for light with a wavelength of 400 to 2200 nm ensures that the light entering the reverse face protection sheet from around photovoltaic devices is reflected and that that the light reflected at the interface between the surface glass or surface protection sheet and the adhesiveness resin returns back into the photovoltaic devices to contribute to power generation, thereby increasing the overall power generation efficiency.

To control the reflectance at 70% or more for light with a wavelength of 400 to 2200 nm coming in through the white polyolefin film of the solar cell module reverse face protection sheet according to the present invention, an effective way is to increase the reflectance of the white polyolefin film in the above wavelength, and increasing the reflectance of the hydrolysis resistant polyester film by adding white fine particles to the hydrolysis resistant polyester film is effective because it serves for the light reaching the hydrolysis resistant polyester film to be reflected back into the white polyolefin film, thereby increasing the reflectance at the white polyolefin film side. To increase the reflectance of the white polyolefin film, it is important to select appropriate white fine particles, and addition of white fine particles comprising inorganic particles with a high refractive index is effective for reflectance improvement. Increasing the content of white fine particles is effective, but it is also effective to increase the thickness of the white polyolefin film if the content is fixed constant.

For the solar cell module reverse face protection sheet according to the present invention, an increase in the heat transmission coefficient serves for the heat generated in photovoltaic devices to be transferred to the solar cell module reverse face protection sheet, thereby decreasing the temperature in the photovoltaic devices. The heat transmission coefficient is defined as the heat conductivity divided by the thickness of the sheet, and accordingly, it increases, thereby serving for efficient diffusion of heat towards the reverse face, with an increasing heat conductivity and with a decreasing sheet thickness. For heat generated in photovoltaic devices to be diffused efficiently towards the reverse face, it is preferable that the heat transmission coefficient for the present invention is 500 W/m$^2$K or more, more preferably 800 W/m$^2$K or more.

To increase the heat conductivity, white fine particles with a high heat conductivity may be added to the white polyolefin film in the solar cell module reverse face protection sheet as described above, but it is also effective to add fine particles with a high heat conductivity to the hydrolysis resistant polyester film.

If the thickness of the sheet is decreased, on the other hand, the dielectric strength characteristics of the sheet will deteriorate and the partial discharge voltage, which is the most important required feature of the solar cell module reverse face protection sheet, will decrease. To prevent a decrease in the partial discharge voltage, it is preferable that an antistatic layer is provided on the reverse face side of the hydrolysis resistant polyester film in the reverse face protection sheet.

To allow the photovoltaic device and wiring to maintain required insulating properties during power generation, it is preferable that the above measures are taken so that the partial discharge voltage of the solar cell module reverse face protection sheet according to the present invention is adjusted to 1,000 V or more.

To ensure an appropriate hydrolysis resistance, it is preferable that the solar cell module reverse face protection sheet according to the present invention has a retained tensile elongation rate of 60% or more in both the vertical direction and the horizontal direction after storage for 72 hours in high pressure steam at 120°C. Hydrolysis resistant solar cell module reverse face protection sheets are high in heat resistance, moisture resistance, and hydrolysis resistance and serve effectively for protection of solar cell modules.

To prevent the solar cell module reverse face protection sheet according to the present invention from suffering from creases during solar cell module production, it is preferable that its shrinkage rate is 0.5% or less in both the vertical direction and the horizontal direction when subjected to heat treatment at 150°C for 30 min.

To ensure that the solar cell module reverse face protection sheet maintains a shrinkage rate of 0.5% or less in both the vertical direction and the horizontal direction after heat treatment at 150°C for 30 min, a known method is, for instance, to first subject it to anneal treatment so that it is shrunk by heating beforehand in order to prevent further shrinkage during subsequent steps such as lamination and thermocompression bonding that apply heat.

To bond a white polyolefin film and a hydrolysis resistant polyester film to from a layered structure for the solar cell module reverse face protection sheet according to the present invention, an usable technique is to apply an adhesive over one of the films, combine it with the other, and achieve firm bonding by applying heat or pressure.

Typical adhesives that can be used for bonding a white polyolefin film and a hydrolysis resistant polyester film include acrylic resin, urethane resin, epoxy resin, polyester resin, polyamide, phenol, polyolefin, ionomer, ethylene / vinyl acetate copolymer, polyvinyl acetal, and copolymers and mixtures thereof.

From the viewpoint of adhesive strength and gas barrier properties, preferable adhesives are acrylic resin, urethane resin, polyester resin, polyolefin, and ionomer.

The adhesive used preferably has a thickness of 1.0 to 10.0 μm, more preferably, 3.0 to 5.0 μm.

In general, photovoltaic devices, an adhesive resin layer, and a surface protection sheet are stacked on a solar cell module reverse face protection sheet with an adhesive resin layer interposed between them, and then the adhesive resin layer is melted by heating, pressure-bonded, and cooled to integrate them into a solar cell module.

The adhesive resin layer in a solar cell module is designed to cover surface irregularities of the photovoltaic devices, protect the devices against temperature changes, humidity, and impact, and ensure firm bonding with the solar cell module surface protection sheet. For adhesive resin layers for solar cell modules, generally known adhesive films can be used, and examples include, for instance, ethylene-vinyl acetate copolymer (hereinafter abbreviated as EVA), ethylene-methyl acrylate copolymer, ethylene-ethyl acrylate copolymer, urethane resin, polyvinyl butyral, partially saponified ethylene-vinyl acetate, silicone resin, and polyester based resin. From the viewpoint of light resistant, permeability, moisture resistance, and economic efficiency, EVA materials, particularly those with a vinyl acetate content of 15 to 40 wt%, are preferred for adhesive resin layers for solar cell modules. With a vinyl acetate content of 15 to 40 wt%, the adhesive resin layer in a solar cell module is sufficiently high in transparency, free from resin stickiness, and high in processability and handleability.

The adhesive resin layer in a solar cell module may contain additives including crosslinking agent (such as organic peroxide), ultraviolet absorber, and antioxidant, as required. An embossing-finished resin sheet may be used to prevent crease formation during heating and melting and improve processability.

Examples

The present invention will now be illustrated with reference to Examples, but it should be understood that the invention is not construed as being limited thereto. The characteristic values for the present invention used in Examples and Comparative examples are measures and evaluated as described below.

· Evaluation methods

The measuring methods used for the various evaluation items in Examples and Comparative examples are described below.

(1) retained elongation rate of polyester film

According to the measuring method specified in JIS C2151 (1996), the tensile elongation of a film specimen with a width of 15 mm and a length of 150 mm was measured under the conditions of an initial chuck-to-chuck distance of 100 mm and a tension speed of 300 mm/min.
After 10-hour storage in high pressure steam at 140°C, the tensile elongation of the film was measured by the same method. For this evaluation, the humidity in the high pressure steam at 140°C corresponds to the saturated water vapor pressure at the temperature.
The retained tensile elongation rate of the film was determined from the ratio of the tensile elongation of the film after storage in high pressure steam at 140°C to the tensile elongation of the film before storage in high pressure steam at 140°C. Measurements were made for three specimens in the machine direction (MD) and three specimens in the transverse direction (TD), and the average over the six specimens was used as representative value for evaluation.

(2) reflectance and absorptance

A UV-3100 spectrophotometer supplied by Shimadzu Corporation was used to measure the transmittance and reflectance of a solar cell module reverse face protection sheet at intervals of 2 nm over the wavelength range of 400 to 2,200 nm. A tungsten lamp was used as light source at a scanning speed of 1,600 nm/min, and an integrating sphere with a diameter of 60 (BIS-3100, supplied by Shimadzu Corporation) was used for measurement.
With respect to the reflectance, barium sulfate was used as reference white plate to measure the diffuse reflectance at an inclination angle of 8°, and the reflectance obtained was taken as the 100% value ($R_R$). Subsequently, the reference white plate was replaced with a specimen with a size of 50 mm × 50 mm, and the diffuse reflectance was measured ($R_S$). Then the measurements were converted by the following equation to give the reflectance (R).

$$R(\%) = R_S / R_R \times 100$$

R: reflectance
$R_R$: reflectance of reference white plate
$R_S$: reflectance of specimen

With respect to the transmittance, a transmittance measurement was made without using a specimen, and the transmittance thus determined was taken as 100% value ($T_R$). Subsequently, the transmittance ($T_S$) of a specimen was measured. Then the measurements were converted by the following equation to give the transmittance (T).

$$T(\%) = T_S / T_R \times 100$$

T: transmittance
$T_R$: transmittance measured without specimen
$T_S$: transmittance of specimen

The absorptance was determined by the following equation.

$$\text{absorptance } (\%) = 100 - (T + R)$$

The average reflectance and absorptance over the wavelength range of 400 to 2,200 nm were determined in this way. The averages of reflectance and absorptance measurements under the condition of n = 3 were used for evaluation.

(3) heat conductivity and heat transmission coefficient

The heat conductivity of the solar cell module reverse face protection sheet is calculated by the following equation from measurements of its specific heat, density, and heat diffusivity.

$$\lambda = \alpha \cdot \rho \cdot Cp$$

$\lambda$: heat conductivity (W/mK)
$\alpha$: heat diffusivity ($m^2$/s)
$\rho$: density (kg/$m^3$)
Cp: specific heat (J/kgK)

The heat diffusivity was determined by the flash method, the density determined by the Archimedian method, and the specific heat determined by DSC.

(I) Measurement of heat diffusivity

Using Netzsch LFA 447 equipment, the heat diffusivity in the thickness direction of a 10 mm $\times$ 10 mm specimen was measured in an air atmosphere at a temperature of 150°C. Measurements under the condition of n = 2 were made and averaged.

(II) Measurement of density

Using water for immersion, the density of a 50 mm $\times$ 50 mm specimen was measured at 25°C. Using an AEL-200 electronic analytical balance supplied by Shimadzu Corporation, measurements under the condition of n = 2 were made and averaged.

(III) Measurement of specific heat

Specific heat measurements were made using a Perkin-Elmer DSC-7 differential scanning calorimeter. In a dry nitrogen flow in an atmosphere at a temperature of 150C, a specimen of about 30 to 50 mg was sampled in a Perkin-Elmer aluminum reference container (diameter 6 mm $\times$ 1 mm), and sapphire ($\alpha$-Al$_2$O$_3$) was used as reference specimen. Measurements under the condition of n = 2 were made at a heating rate of 10°C/min and the results were averaged.

The heat conductivity measured above was divided by the thickness of the sheet to calculate the heat transmission coefficient (W/m$^2$K).

(4) measurement of cell temperature

A single crystal silicon cell was used as photovoltaic device, and a glass plate with a thickness of 3 mm and a solar cell module reverse face protection sheet were attached to its front and reverse faces, respectively. The single crystal silicon cell was then sandwiched between two 1.5-mm-thick plates of EVA (PV-45FR00S supplied by Sanvic Inc.) and sealed to produce a 150 mm × 150 mm layered product for use as specimen. Subsequently, in a chamber adjusted to a temperature of 23±2°C and a humidity 60±5% RH, light from a halogen lamp (output 150W) located 150 mm away was applied to the layered product specimen, and the temperature in the central portion of the reverse face of the single crystal silicon cell, which was opposite to the irradiated face, was measured 60 min later using a thermocouple. Measurements were in °C. Temperatures of 60°C or less were assumed practical.

(5) power generation output improvement rate

In a chamber adjusted to a temperature of 23±2°C and a humidity of 60±5% RH, light from a halogen lamp (output 150W) located 150 mm away was applied to the glass surface of a 150 mm × 150 mm layered product specimen, and measurements were made 60 min later under the condition of n = 5 using I-V Curve Tracer MP-160 supplied by Eko Instruments Co, Ltd., followed by averaging the measurements.
The power generation output improvement rate was determined by the following equation. The effect of the present invention was judged to be significant when the rate was 6% or more.

$$\text{Power generation output improvement rate} = (P_s - P_r) / P_r \times 100 \, (\%)$$

$P_s$: power generation output (W) from a layered product specimen under test
$P_r$: power generation output (W) from a layered product specimen in Comparative example 3

(6) partial discharge voltage

For a 50 mm × 50 mm specimen of the solar cell module reverse face protection sheet, the partial discharge voltage was measured using KPD2050 supplied by Kikusui Electronics Corp.
In a chamber adjusted to a temperature of 23±2°C and a humidity 50±5% RH, the applied voltage was increased from 0 V and the voltage where the electric charge reached 10 pC was taken as the start voltage. The applied voltage was raised to a value 1.1 times the start voltage, and this applied voltage was maintained for 2 sec. Subsequently, the applied voltage was decreased until the electric charge disappeared, and the voltage at this point (threshold 10 pC) was taken as extinction voltage. Measurements of the extinction voltage were made under the condition of n = 10, and the results were averaged to provide a value of the partial discharge voltage to be used for evaluation, which was performed according to the following criteria. A specimen was judged to be acceptable for practical use if ranked as either △ or ○.

○: The partial discharge voltage is 1,000 V or more.
△: The partial discharge voltage is 700 V or more and less than1,000 V.
×: The partial discharge voltage is less than 700 V.

(7) hydrolysis resistance

According to the measuring method specified in JIS C2151 (1996), the tensile elongation of a film specimen with a width of 15 mm and a length of 150 mm was used under the conditions of an initial chuck-to-chuck distance of 100 mm and a tension speed of 300 mm/min.
After 48- or 72-hour storage in high pressure steam at 120°C, the tensile elongation of the film was measured by the same method. For this evaluation, the humidity in the high pressure steam at 120°C corresponds to the saturated water vapor pressure at the temperature.
The retained tensile elongation rate of the film was determined from the ratio of the tensile elongation of the film after storage in high pressure steam at 120°C to the tensile elongation of the film before storage in high pressure steam at 120°C. Measurements were made for three specimens in the machine direction (MD) and three specimens in the transverse direction (TD). The average in the MD and that in the MD were calculated and the smaller was taken for evaluation, which was performed according to the following criteria. A specimen was judged to be acceptable for practical use if ranked as either △ or ○.
○: The retained tensile elongation rate after 72-hour storage is 60% or more.
Δ: The retained tensile elongation rate after 48-hour storage is 60% or more.
✕: The retained tensile elongation rate after 48-hour storage is less than 60%.

Table 1 shows results of various evaluation tests for the samples of the solar cell module reverse face protection sheet produced in Examples 1 to 12 and Comparative examples 1 to 8. The sheet thickness values included in Table 1 show the thickness of each sample of the solar cell module reverse face protection sheet. The structures of the white polyolefin films used in these Examples and Comparative examples are listed in Table 2.

(Example 1)

A 250-μm-thick PET film of Lumirror (registered trademark) X10S supplied by Toray Industries, Inc. was used as hydrolysis resistant polyester film, and a film coater supplied by Okazaki Machine Industry Co., Ltd. was used to treat it for 60 sec at a drying temperature of 160°C. This hydrolysis resistant polyester film had a retained tensile elongation rate of 85%. Subsequently, 1 part by weight of a KR-90 curing agent supplied by DIC Corporation was added to 10 parts by weight of an LX-703 VL adhesive supplied by DIC Corporation, diluted with ethyl acetate to adjust the solid content to 30 wt%, and applied using a film coater supplied by Okazaki Machine Industry Co., Ltd. to form an adhesive layer having a coat layer thickness of 5.0 μm after being dried at a drying temperature of 120°C.
Titanium oxide master batch A containing 60 wt% of rutile type titanium oxide particles with an average particle diameter of 230 nm was produced by subjecting 40 wt% of 1-butene-copolymerized LLDPE with a density of 0.925 g/cm$^3$, melting point of 120°C, and melt flow rate of 5 g/10 min and 60 wt% of rutile type titanium oxide (trade name FTR-700, supplied by Sakai Chemical Industry Co., Ltd.) to melt-kneading in a twin screw extruder, and cutting the resulting strand.
A white polyethylene film (white PE1) with a thickness of 150 μm was produced by adding 35 wt% of titanium oxide master batch A to 65 wt% of 1-butene-copolymerized LLDPE with a density of 0.935 g/cm$^3$, melting point of 127°C, and melt flow rate of 4.5 g/10 min, feeding the mixture to a single screw extruder, melting it at 260°C, introducing it to a T-die, extruding it on a casting drum maintained at 30°C, and applying a cool air flow at 25°C to the surface opposite to the drum to cool and solidify it. The white fine particles of rutile type titanium oxide accounted for 21 wt%. Lumirror X10S and white PE1 were joined together, and cured / aged for 48 hours in an oven at 40°C to prepare a solar cell module reverse face protection sheet.
Because of a high 21 wt% content of rutile type titanium oxide in white PE1, the white PE1 had a high reflectance, and accordingly the solar cell module reverse face protection sheet had a high reflectance, resulting in a decrease in the quantity of light reaching the hydrolysis resistant polyester film, hence a decrease in the absorptance.

(Example 2)

Except that the hydrolysis resistant polyester film of Lumirror X10S supplied by Toray Industries, Inc. had a thickness of 125 μm, the same procedure as in Example 1 was carried out. This hydrolysis resistant polyester film had a retained tensile elongation rate of 85%. As the hydrolysis resistant polyester film was thinner, the absorptance was lower than in the case of Example 1.

(Example 3)

Except that white PE1 had a thickness of 100 μm, the same procedure as in Example 2 was carried out. As white PE1 was thinner, the reflectance was lower and the absorptance was higher than in the case of Example 2.

(Example 4)

An N-103X antistatic coating agent supplied by Colcoat Co., Ltd., isopropyl alcohol, and butanol were mixed at a ratio of 1:1:1 to prepare a coating material.
A surface of a 125-μm-thick film of Lumirror X10S was coated with the coating material prepared above using a film coater supplied by Okazaki Machine Industry Co., Ltd. to form an antistatic layer (AS) having a thickness of 3 g/m$^2$ after being dried at a drying temperature of 120°C.

(Example 5)

Except that the hydrolysis resistant polyester film of Lumirror X10S supplied by Toray Industries, Inc. had a thickness of 75 μm, the same procedure as in Example 4 was carried out. This hydrolysis resistant polyester film had a retained tensile elongation rate of 85%. As the hydrolysis resistant polyester film was thinner, the absorptance was

14

slightly lower than in the case of Example 3.

(Example 6)

Alumina master batch B containing 40 wt% of alumina was produced by subjecting 60 wt% of 1-hexene-copolymerized LLDPE with a density of 0.920 g/cm$^3$, melting point of 117°C, and melt flow rate of 4.8 g/10 min and 40 wt% of alumina particles with an average particle diameter of 180 nm (trade name AS-30, supplied by Showa Denko K.K.) to melt-kneading in a twin screw extruder, and cutting the resulting strand.

A white polyethylene film (white PE2) with a thickness of 100 μm was produced by adding 20 wt% of homopolypropylene resin with a density of 0.900 g/cm$^3$ and a melting point of 160°C, 20 wt% of rutile type titanium oxide master batch A, and 20 wt% of alumina master batch B to 40 wt% of 1-butene-copolymerized LLDPE with a density of 0.930 g/cm$^3$, melting point of 127°C, and melt flow rate of 4.6 g/10 min, and subsequently feeding the mixture to a single screw extruder heated at 240°C. The white fine particles of rutile type titanium oxide accounted for 12 wt%, and alumina accounted for 8 wt%.

One hundred (100) parts by weight of dimethyl terephthalate was mixed with 64 parts by weight of ethylene glycol, and then 0.1 part by weight of zinc acetate and 0.03 part by weight of antimony trioxide were added as catalysts, followed by carrying out ester interchange at the reflux temperature of ethylene glycol.

Polymerization was carried out after adding 0.08 part by weight of trimethyl phosphate. The polymerization degree of the resulting PET was further increased at a treatment temperature and a treatment period controlled in the range of 190 to 230°C and 10 to 23 hours, respectively, to prepare a hydrolysis resistant PET resin with an average weight molecular weight of 25,000 and an intrinsic viscosity [η] of 0.90. This hydrolysis resistant PET resin was compounded with fine alumina particles to provide a PET resin with an alumina content of 30 wt%, which was then heated and melted at 295°C and molded in a T-die to form a sheet. The molded sheet discharged from the T-die was cooled for solidification on a cooling drum with a surface temperature of 25°C to produce an unstretched sheet, which was then fed to a group of rolls heated at 85 to 98°C for 3.3-fold longitudinal drawing in the length direction and fed to a group of rolls adjusted to 21 to 25°C for cooling. Subsequently, the longitudinally drawn film, with both ends gripped by clips, was introduced into a tenter and subjected to 3.6-fold transverse drawing in a direction perpendicular to the length direction in an atmosphere heated at 130°C. This was followed by heat fixation at 220°C in the tenter, cooled gradually and uniformly to room temperature, and wound up in the form of a film with a thickness 75 μm. This film was adopted as white PET.

This hydrolysis resistant polyester film had a retained tensile elongation rate of 65%. Rutile type titanium oxide accounted for 12 wt% in white PE2, and in spite of contribution of alumina particles, the reflectance of the white polyethylene film was lower than that of white PE1. However, the use of white PET actually served to increase the reflectance, and the absorptance was decreased as a result of an increased reflectance of the solar cell module reverse face protection sheet and a decreased thickness of the hydrolysis resistant polyester film.

Except that white PE2 with a thickness of 100 μm and white PET with a thickness of 75 μm were used instead of white PE1 and X10S, respectively, the same procedure as in Example 5 was carried out.

(Example 7)

Antioxidant master batch C was produced by subjecting 80 wt% of 1-hexene-copolymerized LLDPE with a density of 0.925 g/cm$^3$, melting point of 117°C, and melt flow rate of 3.5 g/10 min and 20 wt% of a phosphorus-phenolic antioxidant to melt-kneading in a twin screw extruder, and cutting the resulting strand.

Fluorescent brightening agent master batch D was produced by subjecting 90 wt% of the same LLDPE as above and 10 wt% of 2,5-bis(5-t-butyl-2-benzoxazolyl) thiophene (trade name UVITEX OB, supplied by Nagase & Co., Ltd.) were to melt-kneading in a twin screw extruder, and cutting the resulting strand.

To provide a resin to be used for the A1 layer, 80 wt% of 1-butene-copolymerized LLDPE with a density of 0.935 g/cm$^3$, melting point of 127°C, and melt flow rate of 4.5 g/10 min, 5 wt% of low density polyethylene, and 15 wt% of homopolypropylene were mixed to prepare a resin composition, which was then compounded in a twin screw extruder heated at 220°C.

To provide a resin to be used for the B1 layer, 1-hexene-copolymerized LLDPE with a density of 0.925 g/cm$^3$, melting point of 117°C, and melt flow rate of 4.5 g/10 min was used as the primary component, and 0.05 wt% of antioxidant master batch C, 20.0 wt% of titanium oxide master batch A, 20.0 wt% of alumina master batch B, and 10.0 wt% of fluorescent brightening agent master batch D were added, followed by compounding them in a twin screw extruder heated at 220°C.

To provide a resin to be used for the C1 layer, 65 wt% of 1-butene-copolymerized LLDPE with a density of 0.935 g/cm$^3$, melting point of 127°C, and melt flow rate of 4.5 g/10 min, 10 wt% of low density polyethylene, 20 wt% of homopolypropylene, and 5 wt% of crosslinked polymethyl methacrylate particles (trade name M1002, supplied by Nippon Shokubai Co., Ltd.), i.e., organic particles, were mixed to prepare a resin composition, which was then compounded in a twin screw extruder heated at 220°C.

Each of the resin samples thus prepared was supplied to a uniaxial melt extruder and melt-extruded at 220°C, fed to a multimanifold type, three-resin, three-layered lamination T-die to produce a white polyethylene film (white PE3) in which the A1 layer, the B1 layer, and the C1 layer accounted for 10%, 80%, and 10% of the total thickness. This white film, PE3, consisted of the three layers of A1 layer / B1 layer / C1 layer, in which only the B1 layer contained white fine particles. Accordingly, it did not cause significant contamination of the orifice during the molding step as compared with white PE1 and white PE2, and served for stable, long-term extrusion molding.

Except for using PE3 with a thickness of 100 μm instead of white PE2, the same procedure as in Example 6 was carried out. White PE3 contained a fluorescent brightening agent, and served to increase the reflectance and accordingly decrease the absorptance.

(Example 8)

Except for using white PE2 formed to a thickness of 75 μm instead of white PE1, the same procedure as in Example 5 was carried out. As white PE2 was thinner, the reflectance was lower. However, since the hydrolysis resistant polyester film was thin, it was possible to maintain the absorptance at a low level.

(Example 9)

To provide a resin to be used for the A1 layer, 100 parts by weight of 1-butene-copolymerized LLDPE with a density of 0.935 g/cm$^3$, melting point of 127°C, and melt flow rate of 4.5 g/10 min was mixed with 3.5 parts by weight of LDPE with a density of 0.900 g/cm$^3$, and 10.5 parts by weight of homopolypropylene with a density of 0.900 g/cm$^3$, i.e., propylene based resin, and compounded in a twin screw extruder heated at 220°C. The LDPE and the polypropylene based resin accounted for 3 wt% and 9 wt%, respectively, in the mixture.

To provide a resin to be used for the B1 layer, 100 parts by weight of 1-octene-copolymerized LLDPE with a density of 0.918 g/cm$^3$, melting point of 115°C, and melt flow rate of 5 g/10 min was mixed with 0.1 part by weight of a phosphorus-phenolic antioxidant master batch (based on the same LLDPE, Sumilizer, supplied by Sumitomo Chemical Co., Ltd., GP concentration 10 wt%), and further mixed with 15 parts by weight of titanium oxide master batch A (the titanium oxide content in the B-layer was 7.8 wt%), and compounded in a twin screw extruder heated at 220°C. The phosphorus-phenolic antioxidant accounted for 0.01 wt% in the B-layer resin.

To provide a resin to be used for the C1 layer, as in the case of the resin for the A1 layer, 100 parts by weight LLDPE with a density of 0.935 g/cm$^3$ was mixed with 3.5 parts by weight LDPE with a density of 0.900 g/cm$^3$, and 10.5 parts by weight of homopolypropylene, i.e., propylene based resin, with a density of 0.900 g/cm$^3$ and further mixed with 6 parts by weight of an inorganic particle master batch (based on the same LLDPE, concentration 10 wt%) of aluminum silicate with an average particle diameter of 2 μm (Silton JC30, supplied by Mizusawa Industrial Chemicals, Ltd.) (the content of the inorganic particles in the C1 layer was 0.5 wt%) to prepare a resin composition, which was then compounded in a twin screw extruder heated at 220°C.

Each of the compound resins for the A1 layer, the B1 layer, and C1 layer thus prepared was supplied to a uniaxial melt extruder, melt-extruded at 220°C, fed to a multimanifold type T-die, extruded on a casting drum maintained at 30°C, and exposed to cool air of 25°C applied to the non-drum side for cooling and solidification to produce a white, polyethylene based multi-layered film (white PE4) with a film thickness of 100 μm in which the A1 layer, the B1 layer, and the C1 layer accounted for 15%, 75%, and 10%, respectively, of the total thickness which accounted for 100% . This white film, PE4, consisted of the three layers of A1 layer / B1 layer / C1 layer, in which only the B1 layer contained white fine particles. Accordingly, it did not cause significant contamination of the orifice during the molding step as compared with white PE1 and white PE2, and served for stable, long-term extrusion molding. As Example 9, operations were carried out under the same conditions as in Example 4 except for using white PE4 instead of white PE1. The titanium oxide in the B1 layer had a small content of 7.8 wt%, resulting in a slightly small reflectance of 72.3%, and accordingly, a slightly large absorptance of 8.9%.

(Example 10)

To provide a resin to be used for the A2 layer, 80 parts by weight of 1-butene-copolymerized LLDPE with a melting point of 127°C, density of 0.940 g/cm$^3$, and melt flow rate of 5 g/10 min was mixed with 20 parts by weight of LDPE with a melting point 112°C and density 0.912 g/cm$^3$, and 100 parts by weight of an ethylene-propylene random copolymer, i.e., polypropylene based resin, with a melting point of 150°C and density of 0.900 g/cm$^3$ to prepare a resin mixture. Accordingly, the polyethylene accounted for 50 wt% while the polypropylene based resin accounted for 50 wt%.

To provide a resin to be used for the B2 layer, 100 parts by weight of homopolypropylene with a melting point of 160°C and density of 0.90 g/cm$^3$ was mixed with 12 parts by weight of a titanium oxide master batch (based on homopolypropylene, concentration 60 wt%) to prepare a resin mixture. The titanium oxide accounted for 6.4 wt%.

An ethylene-propylene block copolymer resin with a melting point of 160°C and density of 0.900 g/cm$^3$ was used to provide a resin to be used for the C2 layer.

Each of the resin mixtures for the A2 layer, the B2 layer, and the C2 layer thus prepared was supplied to a uniaxial melt extruder, melt-extruded at 260°C, fed to a multimanifold type T-die, extruded on a casting drum maintained at 30°C, and exposed to cool air of 25°C applied to the non-drum side for cooling and solidification to produce a polypropylene based multi-layered film (white PP1) with a film thickness of 100 $\mu$m in which the A2 layer, the B2 layer, and the C2 layer accounted for 10%, 80%, and 10%, respectively, of the total thickness. This white film, PP1, consisted of the three layers of A2 layer / B2 layer / C2 layer, in which only the B2 layer contained white fine particles. Accordingly, it did not cause significant contamination of the orifice during the molding step as compared with white PE1 and white PE2, and served for stable, long-term extrusion molding. As Example 10, operations were carried out under the same conditions as in Example 4 except for using white PP1 instead of white PE1. The titanium oxide in the B2 layer had a small content of 6.4 wt%, resulting in a slightly small reflectance of 70.6%, and accordingly, a slightly large absorptance of 9.3%.

(Example 11)

Except that a resin to be used for the B1 layer was prepared by mixing 100 parts by weight of LLDPE with a density of 0.918 g/cm$^3$ with 80 parts by weight of titanium oxide master batch A (the titanium oxide content in the B1 layer was 26.7 wt%), the same procedures as in Example 9 was carried out to provide a white, polyethylene based multi-layered film (white PE5). The film served effectively to depress the contamination of the orifice during the molding step as in the case of Example 9. As Example 11, operations were carried out under the same conditions as in Example 4 except for using white PE5 instead of white PE1. The titanium oxide in the B1 layer had a large content of 26.7 wt%, resulting in a high reflectance of 82.5%, and accordingly, a small absorptance of 3.6%.

(Example 12)

Except that the resin used for the B2 layer was a resin mixture prepared by mixing 100 parts by weight of homopolypropylene with melting point of 160°C and density of 0.90 g/cm$^3$ with 70 parts by weight of a titanium oxide master batch (based on homopolypropylene, concentration 60 wt%) (the titanium oxide content in the B2 layer was 24.7 wt%), the same procedures as in Example 10 was carried out to provide a polypropylene based multi-layered film (white PP2). The film served effectively to depress the contamination of the orifice during the molding step as in the case of Example 11. As Example 11, operations were carried out under the same conditions as in Example 4 except for using white PP2 instead of white PE1. The titanium oxide in the B2 layer had a large content of 24.7 wt%, resulting in a high reflectance of 81.0%, and accordingly, a small absorptance of 3.9%.

(Comparative example 1)

Lumirror X10S with a thickness of 250 $\mu$m supplied by Toray Industries, Inc., which was used as hydrolysis resistant polyester film, was bonded to a 150-$\mu$m-thick polyethylene film of LLDPE with a density of 0.940 g/cm$^3$ and melting point of 129°C (hereinafter PE1), and cured/aged for 48 hours in an oven at 40°C to provide a solar cell module reverse face protection sheet. PE1 was a transparent film that had a small reflectance of 15.6%, resulting in a high absorptance of 18.5%.

(Comparative example 2)

Lumirror S 10 with a thickness of 250 $\mu$m supplied by Toray Industries, Inc., which was used as polyester film, was bonded to white PE1 with a thickness of 150 $\mu$m to provide a specimen for Comparative example 2. This polyester film had a retained tensile elongation rate of 10%. The measurements of reflectance and absorptance were near those obtained in Example 1, but the film was low in hydrolysis resistance and unsuitable for practical use.

(Comparative example 3)

A solar cell module reverse face protection sheet with a thickness of 350 $\mu$m, namely, 2442 supplied by Isovolta (consisting of 38 $\mu$m polyvinyl fluoride film (PVF) / 250 $\mu$m polyester film / 38 $\mu$m polyvinyl fluoride film (PVF)), was used for Comparative example 3. The sheet was free from a film containing white fine particles, resulting in a low reflectance and a high absorptance.

(Comparative example 4)

Lumirror X10S with a thickness of 125 μm was used as hydrolysis resistant polyester film, and the same procedure as above was carried out to apply an acrylic adhesive to form a coat layer with a thickness of 5.0 μm. This film of Lumirror X10S was bonded to a 50-μm-thick white polyester film of Lumirror E20 supplied by Toray Industries, Inc. The same procedure as above was carried out to apply an adhesive to the Lumirror E20 side of the combined film, which was then bonded to PE1 with a thickness of 150 μm, followed by curing/aging for 48 hours in an oven at 40°C to provide a solar cell module reverse face protection sheet for Comparative example 4.

(Comparative example 5)

The same procedure as in Comparative example 2 was carried out except that a polyethylene film with a thickness of 50 μm, namely, Torayfan (registered trademark) NO4801 supplied by Toray Advanced Film Co., Ltd., was used instead of the polyethylene film with a thickness of 150 μm used in Comparative example 2 and that an antistatic layer (AS) was bonded to Lumirror X10S in the same way as in Example 4, followed by bonding Lumirror E20 to the opposite side to the antistatic layer.

(Comparative example 6)

Except that a black polyester film with a thickness of 50 μm supplied by Toray Industries, Inc., namely, Toray Industries Lumirror X30, was used instetad of Lumirror E20, the same procedure as in Example 5 was carried out.

(Comparative example 7)

Torayfan NO4801 with a thickness of 50 μm and Lumirror E20 with a thickness of 50 μm were used instead of white PE1 with a thickness of 100 μm and Lumirror X10S with a thickness of 125 μm, respectively, the same procedure as in Example 3 was carried out.

(Comparative example 8)

The same white PP1 film preparation procedure as in Example 10 was carried out except that white PP3 consisting of 100 parts by weight of homopolypropylene and 5 parts by weight of a titanium oxide master batch was used as resin for the B2 layer. The titanium oxide accounted for 2.9 wt%. As Example 8, operations were carried out under the same conditions as in Example 4 except for using this white PP3 film. The titanium oxide in the B2 layer had a small content of 2.9 wt%, resulting in a small reflectance of 45.2%, and accordingly, an increased absorptance of 10.3%.

Table 1 shows that depression of heat generation in photovoltaic devices and improvement in power generation output can be achieved by using a solar cell module reverse face protection sheet having a 10% or less absorptance for light in a wavelength range of 400 to 2,200 nm coming through the surface of the solar cell module. The power generation output can be further improved by using a solar cell module reverse face protection sheet having a 70% or more average reflectance for light over a wavelength range of 400 to 2,200 nm coming through the surface of the solar cell module.

It is also found that further depression of heat generation in photovoltaic devices and further improvement in power generation output can be achieved by decreasing the thickness of the solar cell module reverse face protection sheet and adding highly heat-conductive fine particles to increase its heat conductivity.

The present invention can provide a solar cell module reverse face protection sheet that serves to produce a solar cell module in which photovoltaic devices do not suffer significant temperature rise and have a high power generation efficiency.

[Table 1-1]

| | | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|---|
| Structure | first layer | material | white PE1 | white PE1 | white PE1 | white PE1 | white PE1 | white PE2 | white PE3 | white PE2 | white PE4 | white PP1 | white PE5 | white PP2 |
| | | thickness (μm) | 150 | 150 | 100 | 100 | 100 | 100 | 100 | 75 | 100 | 100 | 100 | 100 |
| | second layer | material | X10S | X10S | X10S | X10S | X10S | white PET | white PET | X10S | X10S | X10S | X10S | X10S |
| | | thickness (μm) | 250 | 125 | 125 | 125 | 75 | 75 | 75 | 75 | 125 | 125 | 125 | 125 |
| | third layer | material | - | - | - | AS | AS | AS | AS | AS | AS | AS | AS | AS |
| | | thickness (μm) | - | - | - | 3 | 3 | 3 | 3 | 3 | 3 | 3 | 3 | 3 |
| | fourth layer | material | - | - | - | - | - | - | - | - | - | | - | |
| | | thickness (μm) | - | - | - | - | - | - | - | - | - | | - | |
| Retained tensile elongation rate of polyester film (%) | | | 85 | 85 | 85 | 85 | 85 | 65 | 65 | 85 | 85 | 85 | 85 | 85 |
| Absorptance (%) | | | 7.4 | 6.2 | 6.5 | 6.5 | 4.8 | 4.6 | 3.1 | 5.1 | 8.9 | 9.3 | 3.6 | 3.9 |
| Reflectance (%) | | | 80.1 | 79.9 | 78.3 | 78.2 | 78.3 | 79.8 | 86.0 | 76.2 | 72.3 | 70.6 | 82.5 | 81.0 |
| Sheet thickness (μm) | | | 405 | 280 | 230 | 233 | 183 | 183 | 183 | 153 | 233 | 233 | 233 | 233 |
| Heat conductivity (W/mK) | | | 0.20 | 0.18 | 0.19 | 0.19 | 0.20 | 0.23 | 0.23 | 0.19 | 0.22 | 0.21 | 0.25 | 0.24 |
| Heat transmission coefficient (W/m²K) | | | 494 | 643 | 826 | 815 | 1093 | 1257 | 1257 | 1242 | 944 | 901 | 1073 | 1030 |
| Cell temperature (°C) | | | 59.7 | 56.5 | 54.8 | 54.9 | 53.7 | 53.1 | 51.2 | 52.3 | 52.6 | 53.3 | 53.0 | 51.4 |
| Power generation output improvement rate (%) | | | 6.7 | 8.6 | 9.5 | 9.5 | 10.2 | 10.6 | 11.9 | 8.8 | 9.0 | 8.6 | 11.0 | 10.5 |
| Partial discharge voltage | | | ○ | ○ | Δ | ○ | ○ | ○ | ○ | Δ | ○ | ○ | ○ | ○ |
| Hydrolysis resistant | | | ○ | ○ | ○ | ○ | ○ | ○ | ○ | ○ | ○ | ○ | ○ | ○ |

[Table 1-2]

| | | | Comparative example 1 | Comparative example 2 | Comparative example 3 | Comparative example 4 | Comparative example 5 | Comparative example 6 | Comparative example 7 | Comparative example 8 |
|---|---|---|---|---|---|---|---|---|---|---|
| Structure | first layer | material | PE1 | white PE1 | PVF | PE1 | 4801 | 4801 | 4801 | white PP3 |
| | | thickness (μm) | 150 | 150 | 38 | 150 | 50 | 50 | 50 | 100 |
| | second layer | material | X10S | S10 | polyester | E20 | E20 | X30 | E20 | X10S |
| | | thickness (μm) | 250 | 250 | 250 | 50 | 50 | 50 | 50 | 125 |
| | third layer | material | - | - | PVF | X10S | X10S | X10S | - | AS |
| | | thickness (μm) | - | - | 38 | 125 | 125 | 125 | - | 3 |
| | fourth layer | material | - | - | - | - | AS | AS | - | - |
| | | thickness (μm) | - | - | - | - | 3 | 3 | - | - |
| Retained tensile elongation rate of polyester film (%) | | | 85 | 10 | - | - | - | - | - | 85 |
| Absorptance (%) | | | 18.5 | 6.8 | 27.1 | 15.2 | 15.3 | 87.5 | 15.1 | 13.0 |
| Reflectance (%) | | | 15.6 | 79.8 | 68.6 | 56.5 | 58.5 | 5.1 | 55.6 | 45.2 |
| Sheet thickness (μm) | | | 405 | 405 | 350 | 335 | 238 | 238 | 108 | 233 |
| Heat conductivity (W/mK) | | | 0.17 | 0.19 | 0.17 | 0.20 | 0.20 | 0.22 | 0.19 | 0.17 |
| Heat transmission coefficient (W/m²K) | | | 420 | 469 | 486 | 597 | 840 | 924 | 1759 | 730 |
| Cell temperature (°C) | | | 57.6 | 58.7 | 70.4 | 63.0 | 61.1 | 104.4 | 58.1 | 55.1 |
| Power generation output improvement rate (%) | | | 0.5 | 6.5 | 0.0 | 4.2 | 5.4 | -21.7 | 6.9 | 4.2 |
| Partial discharge voltage | | | o | o | o | o | o | o | × | o |
| Hydrolysis resistant | | | O | × | × | O | Δ | Δ | × | O |

[Table 2-1]

| Structure | material | | composition | white PE1 | white PE2 | white PE3 | white PE4 | white PE5 |
|---|---|---|---|---|---|---|---|---|
| A1 layer or A2 layer | resin | ethylene/α-olefin copolymer (polyethylene) | wt% | - | - | 80 | 88 | 88 |
| | | low density polyethylene (polyethylene) | | | | 5 | 3 | 3 |
| | | polypropylene based resin | | | | 15 | 9 | 9 |
| B1 layer or B2 layer or monolayer A1 | resin | ethylene/α-olefin copolymer | | 79 | 60 | 79 | 92.2 | 73.3 |
| | | polypropylene based resin | | | 20 | | | |
| | additive | white fine particles (titanium oxide) | | 21 | 12 | 12 | 7.8 | 26.7 |
| | | white fine particles (alumina) | | | 8 | 8 | | |
| | | fluorescent brightening agent | | | | 1 | | |
| | | antioxidant | | | | 0.01 | 0.01 | 0.01 |
| C1 layer or C2 layer | resin | ethylene/α-olefin copolymer | | - | - | 65 | 87.8 | 87.8 |
| | | low density polyethylene | | | | 10 | 2.9 | 2.9 |
| | | polypropylene based resin | | | | 20 | 8.8 | 8.8 |
| | additive | PMMA | | | | 5 | | |
| | | aluminum silicate | | | | | 0.5 | 0.5 |

| Structure | material | composition | white PE1 | white PE2 | white PE3 | white PE4 | white PE5 |
|---|---|---|---|---|---|---|---|
| Thickness | | | 150 $\mu$m (Example 1, 2) | 100 $\mu$m (Example 6) | 100 $\mu$m (Example 7) | 100 $\mu$m (Example 9) | 100 $\mu$m (Example 11) |
| | | | 100 $\mu$m (Example 3 to 5) | 75 $\mu$m (Example 8) | (ratio 10/80/10) | (ratio 15/75/10) | (ratio 15/75/10) |

[Table 2-2]

| Structure | material | | composition | white PP1 | white PP2 | white PP3 |
|---|---|---|---|---|---|---|
| A1 layer or A2 layer | resin | ethylene /α-olefin copolymer (polyethylene) | wt% | 40 | 40 | 40 |
| | | low density polyethylene (polyethylene) | | 10 | 10 | 10 |
| | | polypropylene based resin | | 50 | 50 | 50 |
| B1 layer or B2 layer or monolayer | resin | ethylene /α-olefin copolymer | | | | |
| | | polypropylene based resin | | 93.6 | 75.3 | 97.1 |
| | additive | white fine particles (titanium oxide) | | 6.4 | 24.7 | 2.9 |
| | | white fine particles (alumina) | | | | |
| | | fluorescent brightening agent | | | | |
| | | antioxidant | | | | |
| C1 layer or C2 layer | resin | ethylene /α-olefin copolymer | | | | |
| | | low density polyethylene | | | | |
| | | polypropylene based resin | | 100 | 100 | 100 |
| | additive | PMMA | | | | |
| | | aluminum silicate | | | | |
| Thickness | | | | 100 μm (Example 10) | 100 μm (Example 12) | 100 μm (Comparative example 8) |
| | | | | (ratio 10/80/10) | (ratio 10/80/10) | (ratio 10/80/10) |

Explanation of numerals

1:  surface glass (surface protection sheet)
2:  photovoltaic device

3:    adhesive resin layer
4:    reverse face protection sheet
5:    white polyolefin based film
6:    hydrolysis resistant polyester film
7:    first layer (A1 layer or A2 layer)
8:    second layer (B1 layer or B2 layer)
9:    third layer (C1 layer or C2 layer)

**Claims**

1.  A solar cell module reverse face protection sheet comprising a white polyolefin film containing white fine particles and a hydrolysis resistant polyester film with a retained tensile elongation rate of 60% or more after 10-hour storage in high pressure steam at 140°C, wherein the absorptance is 10% or less for light in the wavelength range of 400 to 2,200 nm coming through the white polyolefin film while the reflectance for light in the same wavelength range is 70% or more.

2.  A solar cell module reverse face protection sheet as defined in Claim 1 wherein the heat transmission coefficient is 500 W/m$^2$K or more.

3.  A solar cell module reverse face protection sheet as defined in either Claim 1 and 2 wherein the partial discharge voltage is 1,000 V or more.

4.  A solar cell module reverse face protection sheet defined in any of Claims 1 to 3 wherein the white polyolefin film comprises the three layers of A1 layer / B1 layer / C1 layer, the A1 layer being formed of a mixture of an ethylene / $\alpha$-olefin copolymer, a low density polyethylene, and a propylene based resin, the B1 layer being formed of a while polyethylene film of an ethylene / $\alpha$-olefin copolymer containing 5 to 30 wt% of white fine particles, and the C1 layer being formed of a mixture of an ethylene / $\alpha$-olefin copolymer, a low density polyethylene, and a propylene based resin.

5.  A solar cell module reverse face protection sheet defined in any of Claims 1 to 3 wherein the white polyolefin film comprises the three layers of A2 layer / B2 layer / C2 layer, the A2 layer being formed of a mixture of polyethylene and a polypropylene based resin, the B2 layer being formed of a polypropylene based resin containing 5 to 50 wt% of white fine particles, and the C2 layer being formed of a polypropylene based resin.

Figure 1

EP 2 573 824 A1

EP 2 573 824 A1

Figure 2

5

6

Figure 3

| INTERNATIONAL SEARCH REPORT | International application No. |
|---|---|
| | PCT/JP2011/061285 |

A.  CLASSIFICATION OF SUBJECT MATTER
*H01L31/042*(2006.01)i, *B32B27/00*(2006.01)i, *B32B27/32*(2006.01)i, *B32B27/36*
(2006.01)i

According to International Patent Classification (IPC) or to both national classification and IPC

B.  FIELDS SEARCHED

Minimum documentation searched (classification system followed by classification symbols)
H01L31/042, B32B27/00, B32B27/32, B32B27/36

Documentation searched other than minimum documentation to the extent that such documents are included in the fields searched
Jitsuyo Shinan Koho          1922-1996    Jitsuyo Shinan Toroku Koho    1996-2011
Kokai Jitsuyo Shinan Koho    1971-2011    Toroku Jitsuyo Shinan Koho    1994-2011

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y<br>A | JP 2010-092958 A  (Toray Advanced Film Co.,<br>Ltd.),<br>22 April 2010 (22.04.2010),<br>paragraphs [0043] to [0052], [0091] to [0111]<br>(Family: none) | 1-3<br>4-5 |
| Y<br>A | JP 2005-313586 A  (Toray Industries, Inc.),<br>10 November 2005 (10.11.2005),<br>paragraphs [0038] to [0039]<br>(Family: none) | 1-3<br>4-5 |
| Y<br>A | JP 2009-170772 A  (Toppan Printing Co., Ltd.),<br>30 July 2009 (30.07.2009),<br>entire text; all drawings<br>(Family: none) | 2-3<br>4-5 |

☐  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 June, 2011 (02.06.11) | 14 June, 2011 (14.06.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006253264 A
- JP 2009147063 A
- JP 2009181989 A